(19) Europäisches Patentamt
European Patent Office
Office européen des brevets

(11) EP 2 528 233 A1

(12) **EUROPEAN PATENT APPLICATION**

(43) Date of publication:
**28.11.2012 Bulletin 2012/48**

(51) Int Cl.:
***H03K 17/722*** (2006.01)    ***H03K 17/16*** (2006.01)

(21) Application number: **11167256.4**

(22) Date of filing: **24.05.2011**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **SIEMENS AKTIENGESELLSCHAFT
80333 München (DE)**

(72) Inventor: **Moen, Stian Oroe
7036, Trondheim (NO)**

(54) **Coupling circuit for coupling a control circuit to a semiconductor switch**

(57)    A coupling circuit adapted to couple a control circuit to a semiconductor switch is provided. The coupling circuit comprises at least a first capacitor and a second capacitor, the coupling circuit being configured such that the first and second capacitors provide a galvanic isolation between the control circuit and the semiconductor switch when the coupling circuit is connected therebetween.

FIG 1

**Description**

BACKGROUND

Electronic coupling circuits are often used to connect a control circuit to a semiconductor switch. Where the connection is between a low voltage control circuit and a high voltage semiconductor, such as a thyristor, galvanic isolation is required to prevent damage to the control circuit. Traditionally, electronic circuits for control of a high voltage semiconductor, such as a thyristor, employ magnetic isolation typically in the form of a transformer or optical isolation typically in the form of an opto-triac.

The use of transformers and opto-triacs to provide galvanic isolation, however, has certain disadvantages. Transformers are typically large and expensive. Opto-triacs have a limited voltage range and are generally not suitable for voltages greater than 800V. In addition, the hardware for both optically-isolated circuits and magnetically-isolated circuits must typically be adapted to the semiconductor to be controlled in order to provide the desired control current.

SUMMARY

The disadvantages in the prior art are overcome in large part by the features of the independent claims. The dependent claims describe embodiments of the invention.

A coupling circuit adapted to couple a control circuit to a semiconductor switch according to an embodiment of the present invention includes at least a first capacitor, a second capacitor, and a rectifier. The first and second capacitors provide galvanic isolation between the control circuit and the semiconductor switch when the coupling circuit is connected therebetween. Use of two capacitors in the present invention to achieve galvanic isolation obviates the need for bulkier, more costly transformers. The rectifier converts alternating current (AC) to direct current (DC) and is coupled between one of either the first or second capacitors and the semiconductor switch.

In an embodiment of the present invention, the first capacitor is coupled between a connection to the control circuit, said connection being adapted to receive a control signal, and a connection to the gate of the semiconductor switch.

In an embodiment of the present invention, the rectifier is coupled between the first capacitor and the connection to the gate of the semiconductor switch, or gate connection. The rectifier may comprise a diode that is coupled between the first capacitor and the gate connection. The rectifier may comprise more than one diode, e.g. a first diode coupled between the first capacitor and the gate connection, and a second diode coupled between the first capacitor and the second capacitor.

In an embodiment of the present invention, the second capacitor is coupled between a second connection to the control circuit, and a connection to the cathode of the semiconductor switch, or cathode connection.

An embodiment of the present invention includes a coupling circuit adapted to receive an alternating current control signal from the control circuit. The coupling circuit is further adapted to provide a rectified control signal, said signal corresponding to the received control signal. In one embodiment of the present invention, the coupling circuit provides the rectified control signal to the semiconductor switch, and specifically to the gate of the semiconductor switch. In one embodiment of the invention, the rectifier is a half-wave rectifier. In one embodiment of the invention, the rectifier is a full-wave rectifier, e.g. a bridge rectifier.

An embodiment of the present invention includes a coupling circuit adapted such that by variation of a frequency of a control signal received from the control circuit, the current provided on the gate connection is adjustable. The coupling circuit is adapted to receive a control signal having a frequency in the range of approximately 100 kHz to approximately 10 MHz.

In an embodiment of the present invention, the first and second capacitors are adapted to provide a first impedance at a first frequency of a load to be controlled by the semiconductor switch. The first and second capacitors are further adapted to provide a second impedance at a second frequency at which a control signal is supplied from the control circuit. The first frequency is in the range of approximately 0.1 Hz to approximately 100 Hz. The second frequency is in the range of approximately 100 kHz to approximately 10 MHz. The impedance is inversely proportional to the frequency. Thus, the first impedance is greater than the second impedance. An embodiment of the present invention includes a first and a second capacitor that are configured such that the first impedance is at least a factor of 100 times, and preferably a factor of at least 1.000 or 10.000 times, greater than the second impedance. The factor may for example lie within a range of about 1.000 to about 200.000.

An embodiment of the present invention provides variable impedance through the first and second capacitors, and variable current to the gate current of the semiconductor switch. In an embodiment of the invention, wherein the oscillator frequency is adjustable, for example through software, a desired impedance and gate current can be achieved by varying the frequency of the control signal provided by the control circuit, thus making it possible for the same control circuit to be used with various semiconductor switches requiring different gate currents without having to modify of the circuit hardware. Such modification of hardware may be required when transformers or opto-triacs are used for galvanic isolation.

In an embodiment of the present invention, at least one of the first capacitor or second capacitor is a printed circuit board (PCB) mounted capacitor. In another embodiment of the present invention, at least one of the first capacitor or second capacitor is implemented by conductor layers of a PCB, e.g. by spaced apart copper layers.

An embodiment of the present invention includes a common mode choke coupled between the first and second capacitors and a connection to the semiconductor switch, wherein the common mode choke filters out voltage spikes in the power circuit of the semiconductor. The common mode choke is suitable for use in conjunction in the present invention with either a half-wave rectifier or a full-wave rectifier.

The semiconductor switch may be a thyristor, a transistor, an insulated gate bipolar transistor (IGBT) or the like.

Another embodiment relates to a control circuit for controlling a semiconductor switch, the control circuit comprising any of the coupling circuits outlined above, the control circuit being coupled to the semiconductor switch by means of said coupling circuit. The control circuit may be a thyristor control circuit.

The features of the aspects and embodiments of the invention mentioned above and those yet to be explained below can be combined with each other unless noted to the contrary.

BRIEF DESCRIPTION OF THE DRAWINGS

A better understanding of the invention is obtained when the following detailed description is considered in conjunction with the accompanying drawings in which:

FIG. 1 is a diagram of a coupling circuit according to an embodiment of the invention;

FIG. 2 is a diagram of a coupling circuit according to an embodiment of the invention in which a full-wave rectifier is employed;

FIG. 3 is a diagram of a coupling circuit according to an embodiment of the invention in which a common mode choke is employed; and

FIG. 4 is a diagram of a coupling circuit according to an embodiment of the invention in which both a full-wave rectifier and a common mode choke are employed.

DETAILED DESCRIPTION

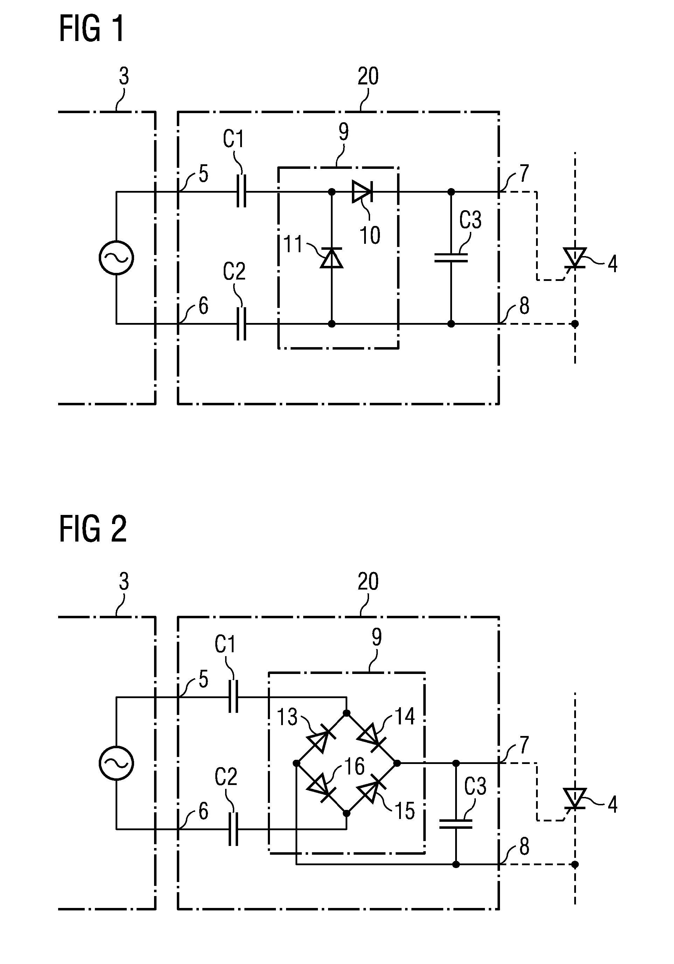

Turning now to the drawings and, with particular attention to FIG. 1, a diagram of a coupling circuit 20 adapted to couple a control circuit 3 to a semiconductor switch 4 according to an embodiment of the present invention is shown. As shown in FIG. 1, the coupling circuit 20 comprises a first capacitor C1, a second capacitor C2, and a rectifier 9. FIG. 1 further shows the coupling circuit's four connections 5, 6, 7 and 8 which connect the coupling circuit between the control circuit 3 and the semiconductor switch 4. The coupling circuit is connected to the control circuit 3 via the first connection 5 and the second connection 6. The connections 5 and 6 are adapted to receive a control signal from the control circuit. The coupling circuit is connected to the semiconductor switch 4 at the gate connection 7 and the cathode connection 8. The first capacitor C1 is coupled between the first connection 5 and the gate connection 7. The second capacitor C2 is coupled between the second connection 6 and the cathode connection 8. The first capacitor C1 and the second capacitor C2 are configured such that they provide galvanic isolation between the control circuit 3 and the semiconductor switch 4 when the coupling circuit is coupled between the control circuit 3 and the semiconductor switch 4. As shown in FIG. 1, the rectifier 9 is coupled between the first capacitor 1 and the gate connection 7. In an embodiment of the present invention, the rectifier is coupled between C2 and the cathode connection 8. The rectifier comprises a diode 10 and a diode 11, wherein the diode 10 is coupled between the first capacitor C1 and the gate connection 7 as shown in FIG. 1. The gate connection 7 is adapted to provide a rectified control signal to the gate of the semiconductor switch. The a second diode 11 is coupled between the first capacitor 1 and the second capacitor 2.

As shown in FIG. 1, the coupling circuit 20 is adapted to receive an alternating current control signal from the control circuit 3 and to provide to the semiconductor switch 4 a rectified control signal corresponding to the received control signal. The coupling circuit is adapted to provide the rectified control signal in particular to the gate of the semiconductor switch via the gate connection 7. The alternating current control signal from the control circuit 3 has a frequency in the range from approximately 100 kHz to approximately 10 MHz, and the load current controlled by the semiconductor switch 4 has a frequency in the range from approximately 0.1 Hz to approximately 100 Hz.

The capacitors 1 and 2 as shown in FIG. 1 are adapted to provide an impedance, X, to oppose the flow of alternating current across the coupling circuit in the direction of the control circuit 3. The impedance $X_c$ of the capacitors C1 and C2 is inversely proportional to the frequency f of an alternating current:

$$X_C = \frac{1}{2\pi f C}$$

For a given capacitor, the impedance that the capacitor provides for the signal increases as frequency decreases and decreases as frequency increases. The capacitors 1 and 2 are therefore configured to provide a first impedance, X1, at a first frequency of a load current controlled by the semiconductor switch, and a second impedance, X2, at a second frequency at which a control signal is supplied from the control circuit. X1 is at least a factor of 1.000 times greater than X2. For example, and not by way of limitation, the factor may lie between about 1.000 and about 200.000, depending on the application. As an example, if the load signal that is to be controlled by the semiconductor switch has a frequency of about 50 Hz and the control signal supplied by the control circuit has a frequency of about 10 MHz, the factor in the impedance which the respective capacitor provides for the two different signals may be about 200.000. Note that this is only an example and that the frequency of the control signal will generally be lower, as mentioned above.

According to an embodiment of the present invention, the current provided via the gate connection 7 to the gate of the semiconductor switch is adjustable by varying the frequency of the control signal received from the control circuit 3 because varying the frequency of the control signal changes the impedance for the control signal at the capacitors. The coupling circuit 20 is thus capable of providing a variable control current to the gate of the semiconductor switch 4. This feature enables the coupling circuit 20 to be used with several different semiconductor switches requiring different gate currents.

FIG. 2 show an embodiment of the invention wherein the rectifier 9 is a full-wave rectifier comprised of four diodes 13, 14, 15 and 16. The configuration of four diodes shown in the diagram is also referred to as a bridge rectifier. As shown in FIG. 2, the rectifier 9 is coupled between the first capacitor 1 and the gate connection 7. This embodiment of the present invention converts both the positive and negative polarities of the alternating current control signal received from the control circuit 3 to direct current to increase the efficiency of the coupling circuit.

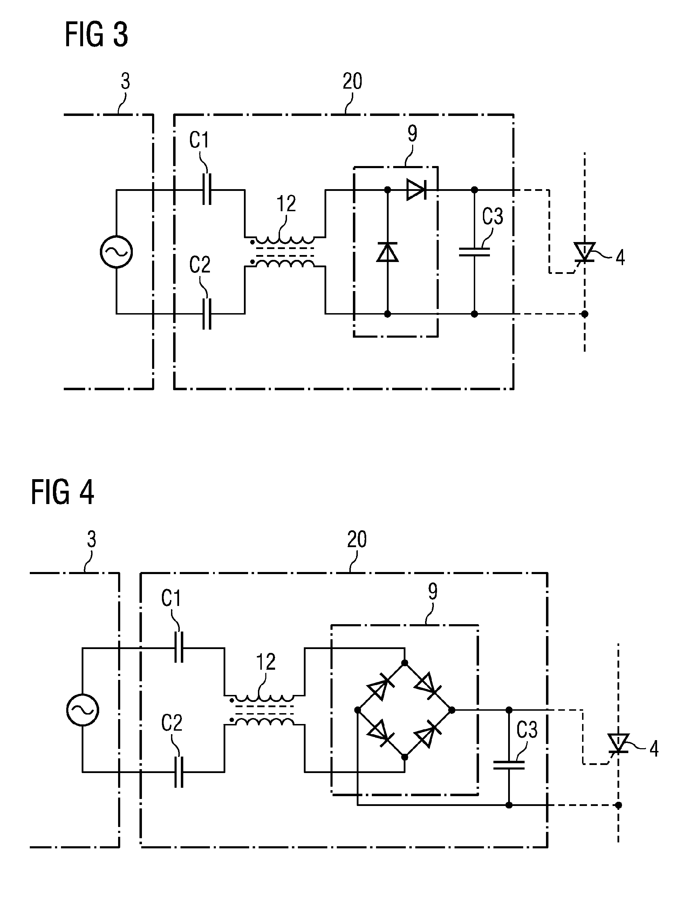

Turning now to FIG. 3, an embodiment of the present invention is shown similar to the embodiment shown in FIG. 1. In FIG. 3, a common mode choke 12 is shown incorporated into the coupling circuit 20. The common mode choke serves to plug or filter out any high frequency spikes generated in the semiconductor switch. The common mode choke is coupled between the two capacitors C1 and C2 and the rectifier 9. In the example of Fig. 3, the common mode choke is coupled to the gate connection 7 via diode 10 of the rectifier 9 and to the cathode connection 8 of the semiconductor switch 4. As shown in FIG. 4, the choke 12 can be incorporated in a coupling circuit of the present invention in conjunction with a full-wave or bridge rectifier 9.

As illustrated in the drawings, a third capacitor C3 may be provided. In the examples of figures 1 - 4, C3 is coupled between the gate connection 7 and the cathode connection 8 in order to provide smoothing of the rectified control signal.

The features of the embodiments described above can be combined with each other so as to form combinations different to the ones explicitly mentioned above.

**Claims**

1. A coupling circuit adapted to couple a control circuit (3) providing an AC control signal to a semiconductor switch (4), wherein the coupling circuit comprises:

    - at least a first capacitor (C1) and a second capacitor (C2), the coupling circuit being configured such that the first and second capacitors provide a galvanic isolation between the control circuit and the semiconductor switch when the coupling circuit is connected therebetween; and
    - a rectifier (9), the coupling circuit being configured such that the rectifier is coupled between at least one of said capacitors and the semiconductor switch when the coupling circuit is connected to the semiconductor switch.

2. The coupling circuit as claimed in claim 1, wherein the first capacitor is coupled between a first connection (5) to the control circuit that is adapted to receive a control signal and a gate connection (7) to the semiconductor switch.

3. The coupling circuit as claimed in claim 2, wherein the rectifier is coupled between the first capacitor and the gate connection of the semiconductor switch.

4. The coupling circuit as claimed in claim 3, wherein the rectifier comprises a diode (10) that is coupled between the first capacitor and the gate connection.

5. The coupling circuit as claimed in any of the preceding claims, wherein the second capacitor is coupled between a second connection (6) to the control circuit and a cathode connection (8) to the semiconductor switch.

6. The coupling circuit as claimed in any of the preceding claims, wherein the rectifier is either a half-wave rectifier or a full-wave rectifier.

7. The coupling circuit as claimed in any of the preceding claims, wherein the coupling circuit is adapted to receive an alternating current control signal from the control circuit and to provide a rectified control signal corresponding to the received control signal to the semiconductor switch, in particular to a gate of the semiconductor switch.

8. The coupling circuit as claimed in claim 7, wherein the coupling circuit is adapted such that by variation of a frequency of a control signal received from the control circuit, the current provided on a connection to a gate of the semiconductor switch is adjustable.

9. The coupling circuit as claimed in claim 8 or 9, wherein the coupling circuit is adapted to receive a control signal having a frequency in the range of about 100 kHz to about 10 MHz.

10. The coupling circuit as claimed in any of the preceding claims, wherein the first and second capacitors are adapted to provide a first impedance at a first frequency range comprising a frequency of a load current that is to be controlled by the semiconductor switch, and to provide a second impedance in a second frequency range comprising a frequency at which a control signal is to be supplied from the control circuit, the first impedance being greater than the second impedance.

11. The coupling circuit as claimed in claim 10, wherein the impedance in the first frequency range is at least a factor of 100, preferably a factor of 1.000, more preferably a factor in a range between about 1.000 and about 200.000 higher than the impedance in the second frequency range.

12. The coupling circuit as claimed in claim 10 or 11, wherein the first frequency range is the range of about 0.1Hz to about 100 Hz and wherein the second frequency range is the range of about 100 kHz to about 10 MHz.

13. The coupling circuit as claimed in any of the preceding claims, wherein at least one, preferably both of said first and second capacitors are printed circuit board mounted capacitors or are implemented by conductor layers of a printed circuit board.

14. The coupling circuit as claimed in any of the preceding claims, further comprising a common mode choke (12) coupled between the first and second capacitors and a connection to the semiconductor switch.

15. A control circuit for controlling a semiconductor switch, the control circuit comprising a coupling circuit (20) according to any of claims 1-14, the control circuit being coupled to the semiconductor switch by means of said coupling circuit (20).

FIG 1

FIG 2

FIG 3

FIG 4

**EUROPEAN SEARCH REPORT**

Application Number

EP 11 16 7256

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 950 918 A (O'BREARTUIN CIARAN [US] ET AL) 21 August 1990 (1990-08-21) | 1-13,15 | INV. H03K17/722 H03K17/16 |
| Y | * the whole document * | 14 | |
| Y | JP 3 218255 A (FUJI ELECTROCHEMICAL CO LTD) 25 September 1991 (1991-09-25) | 14 | |
| A | * abstract; figure 1 * | 1 | |
| A | JP 1 311858 A (FUJI ELECTRIC CO LTD) 15 December 1989 (1989-12-15) * abstract; figure 1 * | 1,14 | |
| A | "LE RELAIS STATIQUE A COMMANDE ISOLEE", ELECTRONIQUE, CEP COMMUNICATION, PARIS, FR, no. 23, 1 December 1992 (1992-12-01), page 68, XP000331164, ISSN: 1157-1152 * the whole document * | 1,6,9-12 | |
| A | US 4 170 740 A (PERNYESZI JOSEPH [US]) 9 October 1979 (1979-10-09) * the whole document * | 1,6,9-12 | **TECHNICAL FIELDS SEARCHED (IPC)** H03K H04L |
| A | US 2003/075990 A1 (GUITTON FABRICE [FR] ET AL) 24 April 2003 (2003-04-24) * paragraph [0030] - paragraph [0033]; figure 3 * | 1,5,9-12 | |
| A | EP 1 427 107 A1 (ST MICROELECTRONICS SA [FR]) 9 June 2004 (2004-06-09) * the whole document * | 1 | |

The present search report has been drawn up for all claims

| Place of search | Date of completion of the search | Examiner |
|---|---|---|
| The Hague | 26 October 2011 | Jepsen, John |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 11 16 7256

This annex lists the patent family members relating to the patent documents cited in the above-mentioned European search report.
The members are as contained in the European Patent Office EDP file on
The European Patent Office is in no way liable for these particulars which are merely given for the purpose of information.

26-10-2011

| Patent document cited in search report | | Publication date | Patent family member(s) | | Publication date |
|---|---|---|---|---|---|
| US 4950918 | A | 21-08-1990 | NONE | | |
| JP 3218255 | A | 25-09-1991 | JP | 1975397 C | 27-09-1995 |
| | | | JP | 7002008 B | 11-01-1995 |
| JP 1311858 | A | 15-12-1989 | JP | 2636340 B2 | 30-07-1997 |
| US 4170740 | A | 09-10-1979 | AR | 224504 A1 | 15-12-1981 |
| | | | AT | 380350 B | 12-05-1986 |
| | | | AU | 519692 B2 | 17-12-1981 |
| | | | AU | 4430679 A | 30-08-1979 |
| | | | BE | 874390 A5 | 23-08-1979 |
| | | | BR | 7901228 A | 02-10-1979 |
| | | | CA | 1121076 A1 | 30-03-1982 |
| | | | CH | 642796 A5 | 30-04-1984 |
| | | | DD | 141744 A5 | 14-05-1980 |
| | | | DE | 2850841 A1 | 30-08-1979 |
| | | | DK | 78879 A | 25-08-1979 |
| | | | ES | 477965 A1 | 16-10-1979 |
| | | | FI | 790606 A | 25-08-1979 |
| | | | FR | 2418576 A1 | 21-09-1979 |
| | | | GB | 2015285 A | 05-09-1979 |
| | | | GR | 66639 A1 | 03-04-1981 |
| | | | HK | 62483 A | 09-12-1983 |
| | | | HU | 182966 B | 28-03-1984 |
| | | | IN | 152152 A1 | 29-10-1983 |
| | | | IT | 1192695 B | 04-05-1988 |
| | | | JP | 1240578 C | 13-11-1984 |
| | | | JP | 54136166 A | 23-10-1979 |
| | | | JP | 59017899 B | 24-04-1984 |
| | | | MX | 146155 A | 19-05-1982 |
| | | | NL | 7901339 A | 28-08-1979 |
| | | | NO | 790555 A | 27-08-1979 |
| | | | NZ | 189635 A | 29-06-1982 |
| | | | PL | 213695 A1 | 17-12-1979 |
| | | | PT | 69277 A | 01-03-1979 |
| | | | RO | 80667 A2 | 01-02-1983 |
| | | | SE | 441559 B | 14-10-1985 |
| | | | SE | 7901568 A | 25-08-1979 |
| | | | SG | 41683 G | 08-03-1985 |
| | | | SU | 1302427 A1 | 07-04-1987 |
| | | | TR | 21272 A | 15-03-1984 |
| | | | YU | 46079 A | 30-04-1983 |
| | | | ZA | 7900759 A | 27-02-1980 |
| US 2003075990 | A1 | 24-04-2003 | CN | 1481562 A | 10-03-2004 |

EPO FORM P0459

For more details about this annex : see Official Journal of the European Patent Office, No. 12/82

**ANNEX TO THE EUROPEAN SEARCH REPORT
ON EUROPEAN PATENT APPLICATION NO.**

EP 11 16 7256

This annex lists the patent family members relating to the patent documents cited in the above-mentioned European search report.
The members are as contained in the European Patent Office EDP file on
The European Patent Office is in no way liable for these particulars which are merely given for the purpose of information.

26-10-2011

| Patent document cited in search report | Publication date | Patent family member(s) | | Publication date |
|---|---|---|---|---|
| US 2003075990 A1 | | EP 1350258 A2 | | 08-10-2003 |
| | | FR 2818824 A1 | | 28-06-2002 |
| | | WO 0250850 A2 | | 27-06-2002 |
| EP 1427107 A1 | 09-06-2004 | JP 4708699 B2 | | 22-06-2011 |
| | | JP 2004200674 A | | 15-07-2004 |
| | | US 2004135620 A1 | | 15-07-2004 |

EPO FORM P0459

For more details about this annex : see Official Journal of the European Patent Office, No. 12/82